(19) Europäisches Patentamt
European Patent Office
Office européen des brevets

(11) EP 1 293 975 A2

(12) **EUROPEAN PATENT APPLICATION**

(43) Date of publication:
**19.03.2003 Bulletin 2003/12**

(51) Int Cl.⁷: **G11B 7/26**

(21) Application number: **02020420.2**

(22) Date of filing: **11.09.2002**

(84) Designated Contracting States:
**AT BE BG CH CY CZ DE DK EE ES FI FR GB GR
IE IT LI LU MC NL PT SE SK TR**
Designated Extension States:
**AL LT LV MK RO SI**

(30) Priority: **13.09.2001 JP 2001277665
14.09.2001 JP 2001280256**

(71) Applicant: **TDK Corporation
Chuo-ku, Tokyo 103-8272 (JP)**

(72) Inventors:
• **Takasaki, Hiroshi
Tokyo 103-8272 (JP)**
• **Ishizaki, Hideki
Tokyo 103-8272 (JP)**
• **Inoue, Hiroyasu
Tokyo 103-8272 (JP)**

(74) Representative: **HOFFMANN - EITLE
Patent- und Rechtsanwälte
Arabellastrasse 4
81925 München (DE)**

(54) **Method and apparatus for the manufacture of optical recording media**

(57)    A method is provided for the manufacture of optical recording media by forming a reflective layer, recording layer and transparent layer on a substrate in this order utilizing appropriately set formation conditions. The reflective layer, recording layer and transparent layer are formed upon the substrate in this order and the deposition rate for said recording layer is set to 5 nm/sec or greater, thereby enabling manufacture of optical recording media with little jitter. The deposition rate for the recording layer is preferably set to 50 nm/sec or less, and the deposition rate for the reflective layer is preferably set to 15 nm/sec or greater.

FIG.2

```
┌─────────────────────────────┐
│  PRODUSE SUBSTRATE 11       │
│  BY INJECTION MOLDING       │── S1
└─────────────────────────────┘
              │
┌─────────────────────────────┐
│  FORM REFLECTIVE LAYER 12   │
│  BY SPUTTERING              │── S2
└─────────────────────────────┘
              │
┌─────────────────────────────┐
│  FORM SECOND DIELECTRIC LAYER 13 │
│  BY SPUTTERING              │── S3
└─────────────────────────────┘
              │
┌─────────────────────────────┐
│  FORM RECORDING LAYER 14    │
│  BY SPUTTERING              │── S4
└─────────────────────────────┘
              │
┌─────────────────────────────┐
│  FORM FIRST DIELECTRIC LAYER 15 │
│  BY SPUTTERING              │── S5
└─────────────────────────────┘
              │
┌─────────────────────────────┐
│  FORM TRANSPARENT LAYER 16  │
│  BY SPIN-COATING            │── S6
└─────────────────────────────┘
```

EP 1 293 975 A2

## Description

## BACKGROUND OF THE INVENTION

The present invention relates to a method and apparatus for the manufacture of optical recording media, and particularly to a method and apparatus for the manufacture of optical recording media of a type wherein a recording layer is formed after the formation of a reflective layer.

## DESCRIPTION OF THE PRIOR ART

In recent years, CD, DVD and other optical recording media have become widely used as recording media for recording large quantities of digital data. Typical optical recording media consist of layers laminated in the order, starting from the side of incident light, a light-transparent substrate, recording layer, reflective layer and a protective layer, so when data is read, the media is illuminated with a laser beam from the light-transparent substrate side and the reflected light is detected.

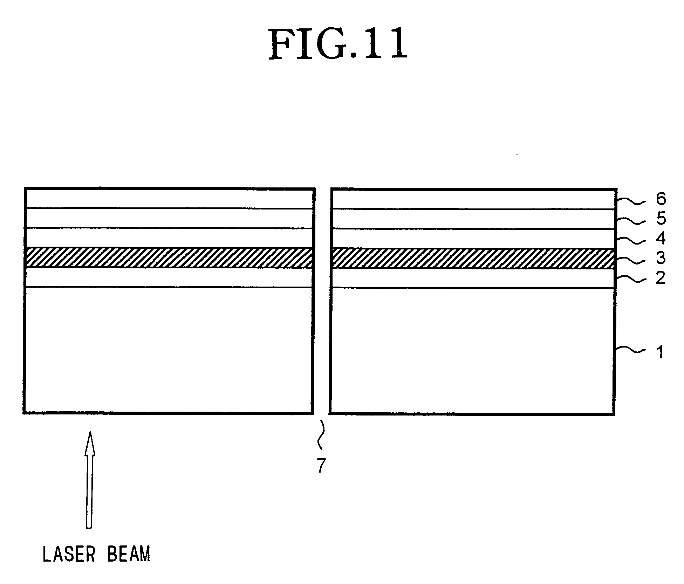

FIG. 11 is a partial cross section schematically showing the structure of a DVD-RW, which is a typical type of optical recording media.

As shown in FIG. 11, a DVD-RW consists of a transparent substrate 1 with a thickness of approximately 0.6 mm, a first dielectric layer 2 with a thickness of 50-80 nm, a recording layer 3 with a thickness of approximately 10-30 nm, a second dielectric layer 4 with a thickness of 10-30 nm, a reflective layer 5 with a thickness of approximately 90-150 nm, and a protective layer 6 with a thickness of approximately 50-80 nm. In addition, a hole 7 is provided in the center of the disc. Typically, the transparent substrate 1 consists of polycarbonate, the first dielectric layer 2 consists of ZnS-SiO$_2$, the recording layer 3 consists of AgInSbTeGe or other phase-change compound, the second dielectric layer 4 consists of ZnS-SiO$_2$, the reflective layer 5 consists of aluminum alloy and the protective layer 6 consists of ultraviolet-cured resin. In the manufacture of a DVD-RW having such a constitution, first, a stamper is used to form by injection molding a transparent substrate 1 that has a pre-groove, and then sputtering is used to form, on the surface that has the pre-groove, the first dielectric layer 2, recording layer 3, second dielectric layer 4 and reflective layer 5 in this order. The protective layer 6 is then formed by spin-coating ultraviolet-cured resin on the surface of the reflective layer 5. A DVD-RW consisting of a transparent substrate 1, first dielectric layer 2, recording layer 3, second dielectric layer 4, reflective layer 5 and protective layer 6 is thus manufactured.

The phase-change compound making up the recording layer 3 has different optical constants when in the crystalline phase from when in the amorphous phase, so digital data can be recorded by taking advantage of this fact.

Recent advances in information technology have created pressing demands for higher-speed and higher-capacity optical recording media as one type of storage media. Effective methods of achieving higher speeds and higher capacity in optical recording media include shortening the wavelength of the laser beam used in recording and/or playback, and raising the numerical aperture (NA) of the optical recording media head.

However, when an optical recording media head with a high NA is used, the problem of the tilt margin becoming small arises. Taking λ to be the wavelength of the laser beam used in recording and/or playback and d to be the thickness of the transparent substrate on which the recording/playback laser is incident, the tilt margin T may be represented by the equation below.

$$T = \frac{\lambda}{d \cdot NA^3} \qquad (1)$$

As is evident from equation (1), the larger the NA of the optical recording head, the smaller the tilt margin becomes. In addition, taking n to be the index of refraction of the transparent layer in which wavefront aberration (coma aberration) occurs and θ to be the angle of inclination, the wavefront aberration coefficient W may be represented by the equation below.

$$W = \frac{d \cdot n^2 \sin\theta \cdot \cos\theta \cdot NA^3}{2(n^2 - \sin^2\theta)^{-\frac{5}{2}}} \qquad (2)$$

As is evident from equations (1) and (2), in order to increase the tilt margin and suppress the occurrence of coma aberration, it is sufficient to reduce the thickness d of the transparent substrate on which the laser is incident. For example, where the thickness of the transparent substrate used in conventional optical recording media represented by the CD (NA=0.45) is approximately 1.2 mm, this is why a thinner transparent substrate with a thickness of approximately 0.6 mm is used in the DVD (NA=0.6).

In order to achieve higher speeds and larger capacities in optical recording media, it has been proposed to increase the NA of the optical recording media head to roughly 0.85, but in this case, in order to increase the tilt margin and suppress coma aberration, it would be necessary to reduce the thickness of the transparent substrate to a thin 0.1 mm.

However, if the current method of injection molding using polycarbonate or the like as the raw material for the transparent substrate is used, and the film thickness is made as thin as roughly 0.1 mm, there is a problem in that sufficient mechanical strength cannot be obtained.

In order to solve this problem, an optical storage medium with a thin transparent layer serving as the light path for the laser beam has been proposed, made by forming upon the substrate of polycarbonate or the like, a reflective layer, second dielectric layer, recording layer, first dielectric layer and transparent layer, in this order. With this type of optical recording media, the laser beam is incident from the opposite side from the substrate, so the thickness of the substrate can be made sufficiently thick. Accordingly, if this type of optical recording media is used, the substrate can be given sufficient mechanical strength while a high-*NA* optical recording media head can be used. When such a high-*NA* optical recording media head is used, the beam spot of the laser beam can be made extremely small, so the track pitch and group width can be made much narrower than in the typical DVD-RW as described above.

Even with this type of optical recording media, the conventional sputtering method can be used fundamentally without modification as the method used to form the reflective layer, dielectric layer, recording layer and other layers, but because the order of layer formation (deposition) is different than that of the aforementioned typical DVD-RW, and the track pitch and group width are also different from those of the aforementioned typical DVD-RW, the appropriate deposition conditions are thought to be different from those of the aforementioned typical DVD-RW. In addition, in the manufacture of this type of optical recording media, abnormal electrical discharge may occur during sputtering and not only does this abnormal electrical discharge degrade the quality of the layer being formed, but the previously formed layers may also be scorched in certain cases. For this reason, the occurrence of abnormal electrical discharge is a major cause of degradation of the quality of optical recording media.

**SUMMARY OF THE INVENTION**

It is therefore an object of the present invention to provide a method for the manufacture of optical recording media wherein the deposition conditions are set appropriately, and a manufacturing apparatus that is able to implement the same.

A further object of the present invention is to provide an improved method for the manufacture of optical recording media of a type wherein the reflective layer, recording layer and transparent layer are formed upon the substrate in this order, and a manufacturing apparatus that is able to implement the same.

A still further object of the present invention is to provide, in a method for the manufacture of optical recording media of a type wherein the reflective layer, recording layer and transparent layer are formed upon the substrate in this order, and a manufacturing apparatus that is able to implement same, a method for the manufacture of optical recording media wherein the deposition conditions are set appropriately, and a manufacturing apparatus that is able to implement the same.

The object of the present invention is achieved by a method of manufacturing optical recording media wherein the reflective layer, recording layer and transparent layer are formed upon the substrate in this order, where the deposition rate for said recording layer is set to 5 nm/sec or greater, and a manufacturing apparatus that is able to implement the same.

According to the present invention, the deposition rate for the recording layer is set appropriately, so it is possible to manufacture optical recording media with little jitter.

In a preferred embodiment of the present invention, the deposition rate for said recording layer is set to 50 nm/sec or less.

In a further preferred embodiment of the present invention, the deposition rate for said reflective layer is set to 15 nm/sec or less.

In a further preferred embodiment of the present invention, said reflective layer and said recording layer are formed by sputtering and said recording layer is formed by spin-coating.

In a further preferred embodiment of the present invention, the second dielectric layer is formed by sputtering between said reflective layer and said recording layer, and the first dielectric layer is formed by sputtering between said recording layer and said transparent layer.

A still further object of the present invention is to provide a method for the manufacture of optical recording media that prevents the occurrence of abnormal electrical discharge during deposition.

In addition, a still further object of the present invention is to provide an improved method for the manufacture of optical recording media of a type that is produced by forming one or two or more layers upon the reflective layer by sputtering.

According to research carried out by the inventors, the aforementioned occurrence of abnormal electrical discharge was found to be caused by performing deposition in a state wherein the sputtering mask and reflective layer are in contact. The present invention is based on this technical knowledge, and the aforementioned objects are achieved by means of a method for the manufacture of optical recording media comprising: a first step of forming a reflective layer by sputtering in a deposition region upon the substrate demarcated by a mask and a second step of forming one or more layers by sputtering in the deposition region upon said reflective layer demarcated by said mask, wherein said second step is performed in the state wherein said mask is not in contact with said reflective layer.

With the present invention, sputtering is performed in a state in which the mask and reflective layer are not in contact, so the occurrence of abnormal electric discharge is effectively prevented. Thereby, deterioration of the layer quality is prevented and it is thus possible to increase the quality of the optical recording media.

In a preferred embodiment of the present invention, bevels are provided on said mask in order to form portions that are in shadow with respect to the target, thereby preventing contact between said mask and said reflective layer.

In a further preferred embodiment of the present invention, the width of said bevels is 0.1-1.0 mm.

In a further preferred embodiment of the present invention, the angle of said bevels is 5-85 degrees.

In a further preferred embodiment of the present invention, the gas pressure for sputtering in the aforementioned first step and second step is set to 0.1-1.0 Pa.

In a further preferred embodiment of the present invention, said mask includes an inside mask that demarcates the inside of said deposition region and an outside mask that demarcates the outside of said deposition region.

In this case also, the deposition rate for the recording layer is preferably set to 5 nm/sec to 50 nm/sec, and the deposition rate for the reflective layer is preferably set to 15 nm/sec or greater.

Note that in this Specification, the phrase "in this order" has the meaning of "in this order with respect to the layers in question" and does not exclude the presence of other layers between the layers in question. Accordingly, even cases wherein other layers are interposed between the layers in question are included in the phrase "in this order" as long as the order is maintained with respect to the layers in question.

**BRIEF DESCRIPTION OF THE DRAWINGS**

FIG. 1 is a schematic partial cross section showing the structure of the optical recording media 10 to be manufactured by a method according to a preferred embodiment of the present invention.
FIG. 2 is a flowchart showing the method of manufacturing the optical recording media 10.
FIG. 3 is a schematic cross section showing the state in which the substrate 11 is held by the substrate holder 20, inside mask 30 and outside mask 40.
FIG. 4 is a top view showing the exterior of the inside mask 30.
FIG. 5 is a cross section along the line A-A of FIG. 4.
FIG. 6 is a top view showing the exterior of the outside mask 40.
FIG. 7 is a cross section along the line B-B of FIG. 6.
FIG. 8 is a graph showing the relationship between the deposition rate for the recording layer 14 and the jitter in the produced optical recording media 10.
FIG. 9 is a graph showing the relationship between the deposition rate for the reflective layer 12 and the jitter in the produced optical recording media 10.
FIGs. 10(a) and (b) are schematic cross sections showing another example of the shape of the bevels.
FIG. 11 is a schematic partial cross section showing the structure of a DVD-RW which is a typical type of optical recording media.

**DESCRIPTION OF THE PREFERRED EMBODIMENTS**

Here follows a detailed description of preferred embodiments of the present invention made with reference to the appended drawings.

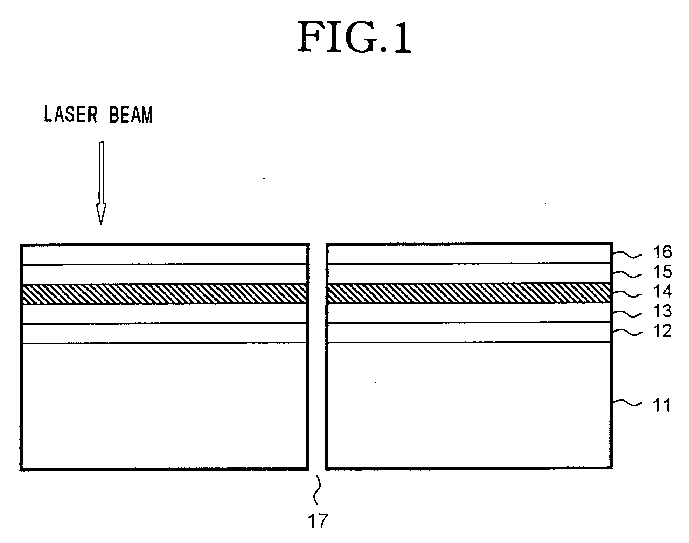

FIG. 1 is a schematic partial cross section showing the structure of the optical recording media 10 to be manufactured by a method according to a preferred embodiment of the present invention.

As shown in FIG. 1, the optical recording media 10 consists of a substrate 11 with a thickness of approximately 1.1 mm, a reflective layer 12 with a thickness of 50-200 nm, a second dielectric layer 13 with a thickness of 10-30 nm, a recording layer 14 with a thickness of approximately 10-30 nm, a first dielectric layer 15 with a thickness of 30-150 nm, and a transparent layer 16 with a thickness of approximately 100 μm. In addition, a hole 17 is provided in the center of the optical recording media 10. The substrate 11 consists of polycarbonate, a polyolefin or other resin, the reflective layer 12 consists of an alloy of silver, the second dielectric layer 13 consists of $Al_2O_3$, the recording layer 14 consists of AgInSbTeGe, the first dielectric layer 15 consists of $ZnS-SiO_2$, and the transparent layer 16 consists of ultraviolet-cured resin, polycarbonate, a polyolefin or other resin sheet.

At the time of reading data from the optical recording media 10 with such a structure, the transparent layer 16 side is irradiated with a laser beam having a wavelength in the range 380-450 nm, and 405 nm in particular. The laser beam passes through the recording layer 14, is reflected by the reflective layer 12, passes again through the recording layer 14 and returns from the transparent layer 16. Here, the AgInSbTeGe making up the recording layer 3 is a phase-change compound that has different optical constants when in the crystalline phase as when in the amorphous phase, so by detecting the intensity of the reflected laser beam light, it is possible to determine whether the recording layer 14 in the portion irradiated with the laser beam is in the crystalline phase or the amorphous phase. The difference between the recording layer 14 being in the crystalline phase or the amorphous phase corresponds to the recorded digital data, so by distinguishing this it is possible to read the recorded digital data.

On the other hand, when writing data to the optical recording media 10, the transparent layer 16 side is irradiated with a laser beam having a wavelength in the range 380-450 nm, and 405 nm in particular, and thereby the state of the recording layer 14 in the portion in question assumes either the crystalline phase or amorphous phase. It is thus possible to record the desired digital data on the recording layer 14.

In addition, the second dielectric layer 13 and first dielectric layer 15 provided on either side of the recording layer 14 also function as protective layers for the recording layer 14.

The method of manufacturing the optical recording media 10 will now be explained.

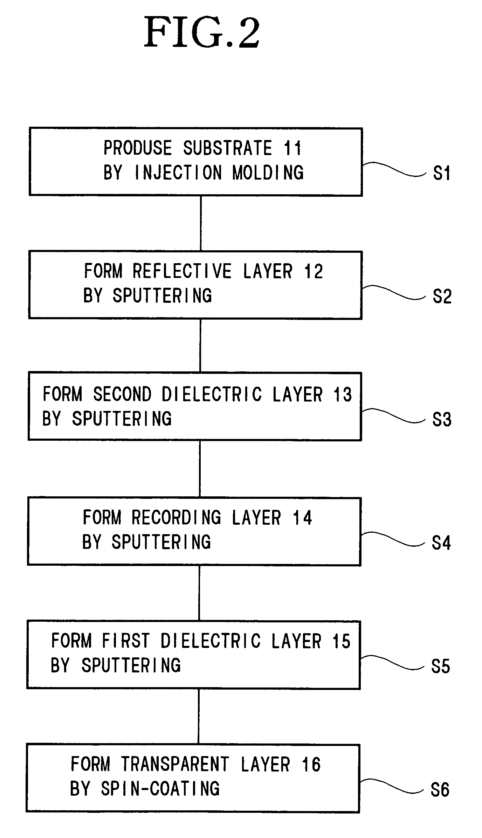

FIG. 2 is a flowchart showing the method of manufacturing the optical recording media 10. As described above, the thickness of the transparent layer 16 of the optical recording media 10 is extremely thin approximately 100 μm, and for this reason, deposition is performed in the opposite order from that of a conventional typical DVD-RW.

First, a stamper is used to form by injection molding a substrate 11 with a thickness of 1.1 mm that has a pre-groove with groove width of 0.1-0.2 μm, track pitch of approximately 0.3 μm, and a groove depth of approximately 20 nm (Step S1).

Next, the substrate 11 is placed upon a substrate holder such that the surface that has the pre-groove formed therein is exposed, and then the inside mask and outside mask are placed.

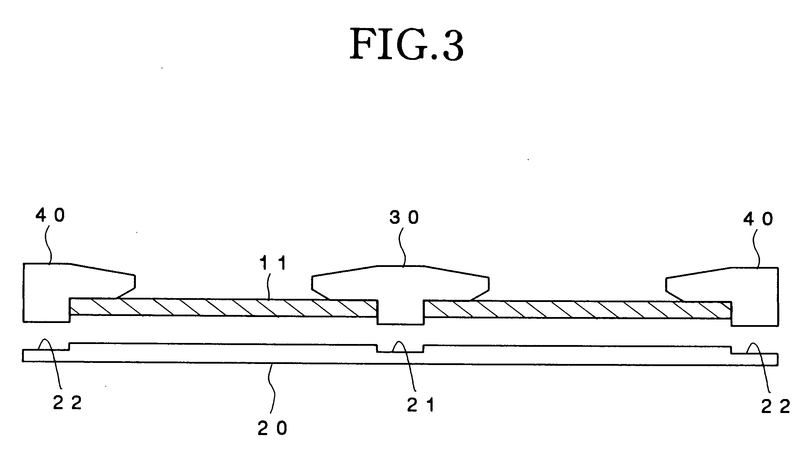

FIG. 3 is a schematic cross section showing the state in which the substrate 11 is held by the substrate holder 20, inside mask 30 and outside mask 40. Note that in FIG. 3, the substrate 11, inside mask 30 and outside mask 40 are shown separated from the substrate holder 20 for the sake of clarity.

As shown in FIG. 3, the inside mask 30 covers a stipulated portion of the inside of the top surface of the substrate 11, and also fits into the hole 17 provided on the substrate 11 and an indentation 21 provided in the center of the substrate holder 20, thereby preventing the formation of layer on the inside portion of the substrate 11 during sputtering and also serving to secure the substrate 11 to the substrate holder 20. In addition, the outside mask 40 covers a stipulated portion of the outside of the top surface of the substrate 11, and also fits into an indentation 22 provided on the outside of the substrate holder 20, thereby preventing the formation of layer on the outside portion of the substrate 11 during sputtering and also serving to secure the substrate 11 to the substrate holder 20.

There is no particular limitation to the material for the inside mask 30 and outside mask 40, but metal may be used and stainless steel is preferably used in consideration of durability.

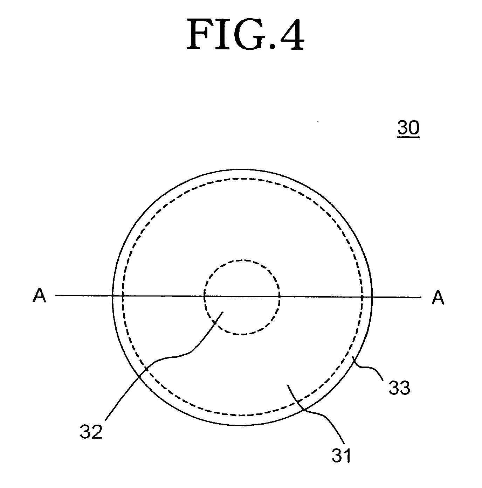

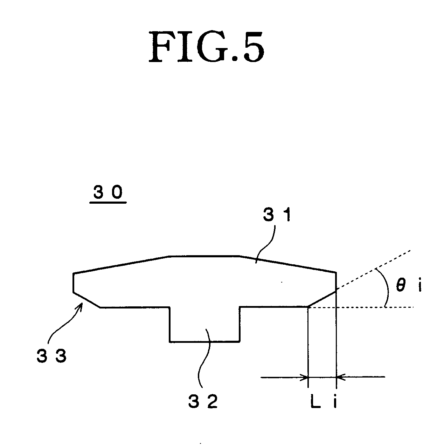

FIG. 4 is a top view showing the exterior of the inside mask 30, while FIG. 5 is a cross section along the line A-A of FIG. 4.

As shown in FIG. 4 and FIG. 5, the inside mask 30 consists of a disc-shaped main body 31 and a cylindrical protrusion 32 provided in its center, while a bevel 33 is formed around the edge (periphery) of the main body 31. While there are no particular limitations, the outside diameter of the main body 31 is preferably set to approximately 40 mm, and the outside diameter of the protrusion 32 is preferably set to approximately 15 mm. The main body 31 covers a stipulated portion of the inside of the top surface of the substrate 11 to prevent deposition on this portion, thereby assuming the role of demarcating the inside of the deposition region. In addition, the protrusion 32 passes through the hole 17 provided on the substrate 11 and fits into an indentation 21 provided in the center of the substrate holder 20, thereby serving to secure the substrate 11 to the substrate holder 20.

As shown in FIG. 5, the bevel 33 is a portion where the main body 31 is cut away at an angle of $\theta_i$ up to a distance $L_i$ from the edge, and this bevel 33 prevents contact between the edge of the main body 31 and the substrate 11. In this embodiment, $L_i$ is preferably set in the range 0.1-1.0 mm, and more preferably set in the range 0.1-0.8 mm. In addition, in this embodiment, $\theta_i$ is preferably set in the range 5-85 degrees, and more preferably set in the range 15-60 degrees. In this Specification, the distance $L_i$ is called the "width" of the bevel 33 and the angle $\theta_i$ is called the "angle" of the bevel 33.

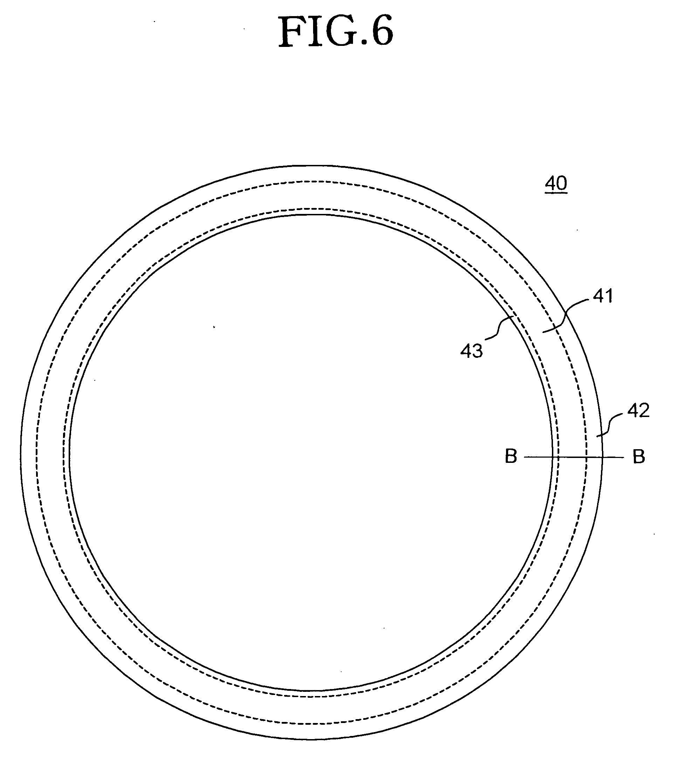

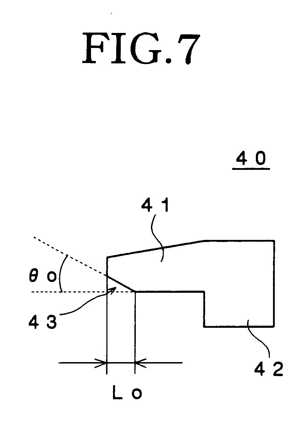

FIG. 6 is a top view showing the exterior of the outside mask 40, while FIG. 7 is a cross section along the line B-B of FIG. 6.

As shown in FIG. 6 and FIG. 7, the outside mask 40 consists of an annular main body 41 and an annular protrusion 42 provided on its periphery, while a bevel 43 is formed around the edge (inside edge) of the main body 41. While there are no particular limitations, the inside diameter of the main body 41 is preferably set to approximately 118 mm. The main body 41 covers a stipulated portion of the outside of the top surface of the substrate 11 to prevent deposition on this portion, thereby assuming the role of demarcating the outside of the deposition region. In addition, the protrusion 42 fits into an indentation 22 provided on the periphery of the substrate holder 20, thereby serving to secure the substrate 11 to the substrate holder 20.

As shown in FIG. 7, the bevel 43 is a portion where the main body 41 is cut away at an angle of $\theta_o$ up to a distance $L_o$ from the edge, and this bevel 43 prevents contact between the edge of the main body 41 and the substrate 11. In this embodiment, $L_o$ is preferably set in the range 0.1-1.0 mm, and more preferably set in the range 0.1-0.8 mm. In addition, in this embodiment, $\theta_o$ is preferably set in the range 5-85 degrees, and more preferably set in the range 15-60 degrees. In this Specification, the distance $L_o$ is called the "width" of the bevel 43 and the angle $\theta_o$ is called the "angle" of the bevel 43.

The substrate 11 that is held by the substrate holder 20, inside mask 30 and outside mask 40 is carried into the first chamber (not shown) of a sputtering system. A target made of an alloy of silver is provided in the interior of the first chamber of the sputtering system.

Next, the interior of the first chamber is evacuated to a pressure of approximately $1 \times 10^{-4}$ Pa and then argon gas is introduced into the interior of the first chamber, the gas pressure is set to 0.1-1.0 Pa, and then sputtering is performed by applying a DC voltage or RF voltage to the target. Thereby, a reflective layer 12 with a thickness of 50-200 nm is formed over the entire upper surface of the substrate 11 except for the portions covered by the inside mask 30 and outside mask 40 (Step S2). The deposition rate for the reflective layer 12 is preferably set to 15-150 nm/sec.

During this deposition, a small amount of the reflective layer 12 is also formed in the portion covered by the bevel 33 of the inside mask 30 and the portion covered by the bevel 43 of the outside mask 40, namely the portions that are in shadow with respect to the target, but the gas pressure is set to a relatively low 0.1-1.0 Pa, so the advancement of the deposition material emitted from the target is high and also the shape and size of the bevels 33 and 43 are set as described above, so an extremely small amount of the deposition material reaches the portions covered by the bevels 33 and 43. For this reason, there is little deposition on those portions of the upper surface of the substrate 11 covered by the bevels 33 and 43, being limited to a small amount of deposition at the entrance portions. Accordingly, the reflective layer 12 thus formed is not in contact with the inside mask 30 or outside mask 40.

When the formation of the reflective layer 12 is complete in this manner, the substrate 11 that is held by the substrate holder 20, inside mask 30 and outside mask 40 is carried from the first chamber into the second chamber (not shown). A target made of $Al_2O_3$ is provided in the interior of the second chamber of the sputtering system. Next, the interior of the second chamber is evacuated to a pressure of approximately $1 \times 10^{-4}$ Pa and then argon gas is introduced into the interior of the second chamber and sputtering is performed with the gas pressure set to 0.1-1.0 Pa. Thereby, a second dielectric layer 13 with a thickness of 10-30 nm is formed over the entire upper surface of the reflective layer 12 except for the portions covered by the inside mask 30 and outside mask 40 (Step S3). The deposition rate for the second dielectric layer 13 is preferably set to 1-20 nm/sec.

This sputtering is performed on the upper surface of the reflective layer 12 which is metal, but as described above, the reflective layer 12 is not in contact with the inside mask 30 and outside mask 40, so the occurrence of abnormal electric discharge which happens when these come into contact is effectively suppressed. Note that the inside mask 30 and outside mask 40 are also used in the formation of the second dielectric layer 13, so there is little deposition on those portions of the upper surface of the reflective layer 12 covered by the bevels 33 and 43, being limited to a small amount of deposition at the entrance portions. Accordingly, the second dielectric layer 13 thus formed is not in contact with the inside mask 30 or outside mask 40.

When the formation of the second dielectric layer 13 is complete in this manner, the substrate 11 that is held by the substrate holder 20, inside mask 30 and outside mask 40 is carried from the second chamber into the third chamber (not shown). A mixed target made of Ag, In, Sb, Te and Ge is provided in the interior of the third chamber of the sputtering system. Next, the interior of the third chamber is evacuated to a pressure of approximately $1 \times 10^{-4}$ Pa and then argon gas is introduced into the interior of the third chamber and sputtering is performed with the gas pressure set to 0.1-1.0 Pa. Thereby, a recording layer 14 with a thickness of 10-30 nm is formed over the entire upper surface of the second dielectric layer 13 except for the portions covered by the inside mask 30 and outside mask 40 (Step S4). A preferable deposition rate of the recording layer 14 are described later. In this step also, the reflective layer 12 and second dielectric layer 13 formed previously are not in contact with the inside mask 30 or outside mask 40, so the occurrence of abnormal electric discharge is effectively suppressed.

When the formation of the recording layer 14 is complete in this manner, the substrate 11 that is held by the substrate holder 20, inside mask 30 and outside mask 40 is carried from the third chamber into the fourth chamber (not shown). A mixed target made of ZnS and $SiO_2$ is provided in the interior of the fourth chamber of the sputtering system. Next, the interior of the fourth chamber is evacuated to a pressure of approximately $1 \times 10^{-4}$ Pa and then argon gas is introduced into the interior of the fourth chamber and sputtering is performed with the gas pressure set to 0.1-1.0 Pa. Thereby, a first dielectric layer 15 with a thickness of 30-150 nm is formed over the entire upper surface of the recording layer 14 except for the portions covered by the inside mask 30 and outside mask 40 (Step S5). The deposition rate for the first dielectric layer 15 is preferably set to 1-20 nm/sec. In this step also, the reflective layer 12, second dielectric layer 13 and recording layer 14 formed previously are not in contact with the inside mask 30 or outside mask 40, so the occurrence of abnormal electric discharge is effectively suppressed.

When the formation of the reflective layer 12, second dielectric layer 13, recording layer 14 and first dielectric layer 15 upon the substrate 11 is complete in this manner, the substrate 11 on which these layers are formed is taken out of the fourth chamber and the substrate holder 20, inside mask 30 and outside mask 40 are removed. Moreover, the surface of the first dielectric layer 15 is coated with ultraviolet-curable resin by spin-coating and it is irradiated with ultraviolet light to form a transparent layer 16 with a thickness of approximately 100 μm (Step S6). Thereby, the optical recording media 10 is produced. Note that the formation of the transparent layer 16 may be performed by adhering a previously formed resinous sheet material of polycarbonate, a polyolefin or the like to the surface of the first dielectric layer 15.

In this manner, sputtering is used in all of the steps from the formation of the reflective layer 12 through the formation of the first dielectric layer 15. For this reason, by using a multi-chamber sputtering system in the steps from the formation of the reflective layer 12 through the formation of the first dielectric layer 15, the steps from the formation of the reflective layer 12 through the formation of the first dielectric layer 15 are preferably performed continuously while maintaining the evacuated state. By performing the various sputtering steps continuously while maintaining the evacuated state in this manner, it is possible to improve productivity and suppress the introduction of impurities into the optical recording media 10.

Here follows a description of preferable conditions in the formation of the recording layer 14 (Step S4).

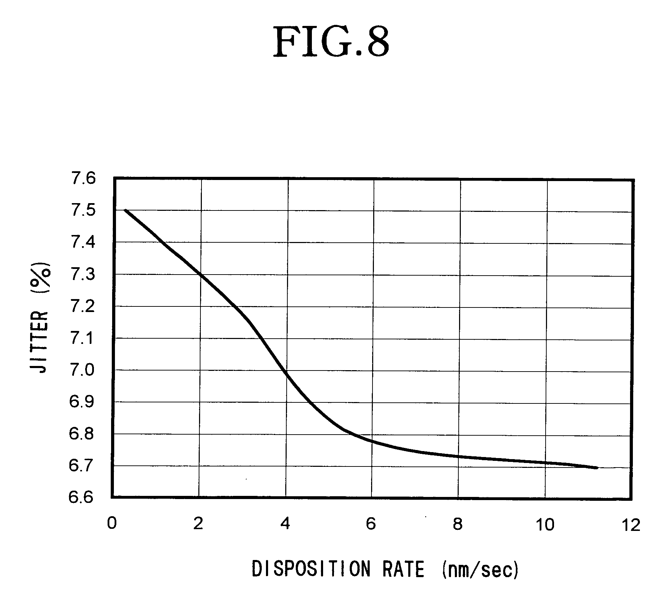

FIG. 8 is a graph showing the relationship between the deposition rate for the recording layer 14 and the jitter in the produced optical recording media 10.

As shown in FIG. 8, the jitter in the produced optical recording media 10 is seen to tend to decrease the higher the deposition rate for the recording layer 14. This decrease in jitter is marked in the region in which the deposition rate for the recording layer 14 is less than approximately 5 nm/sec, but it does not change greatly in the region above approximately 5 nm/sec. Because of this, it is preferable to set the deposition rate for the recording layer 14 to approximately 5 nm/sec or greater.

The reason why the jitter in the produced optical recording media 10 depends on the deposition rate for the recording layer 14 is thought to be because various types of layer formation (deposition) by sputtering is performed with respect to the substrate 11 on which the reflective layer 12 is formed. To wit, when the second dielectric layer 13 is formed by sputtering on the surface of the reflective layer 12, the reflective layer 12 serving as the base material is metal and this is thought to affect not only the quality of the second dielectric layer 13 but also the quality of the recording layer 14 that is formed on its surface. In addition, in the optical recording media 10, since the groove is made narrower and the track pitch is narrower than in a conventional typical DVD, the aforementioned effects are made tangible.

Note that in consideration of productivity, the deposition rate for the recording layer 14 is preferably as high as possible. From this standpoint, the deposition rate for the recording layer 14 is preferably set to be faster in the region above approximately 5 nm/sec. In order to increase the deposition rate for the recording layer 14, it is sufficient to increase the electrical power applied during sputtering or narrow the distance between the target and substrate 11. However, if the electrical power during sputtering is made too high or the distance between the target and substrate 11 is made too narrow, heating of the substrate 11 becomes marked and it becomes no longer possible to use the polycarbonate used preferably as the material for the substrate 11. Moreover, if the deposition rate for the recording layer 14 is set too high, the deposition time becomes extremely short, so accurate control of the layer thickness becomes difficult. In consideration of this viewpoint, it is preferable that the deposition rate for the recording layer 14 be set to a rate no greater than approximately 50 nm/sec.

Summarizing the above, the deposition rate for the recording layer 14 is preferably set in the range of approximately 5-50 nm/sec.

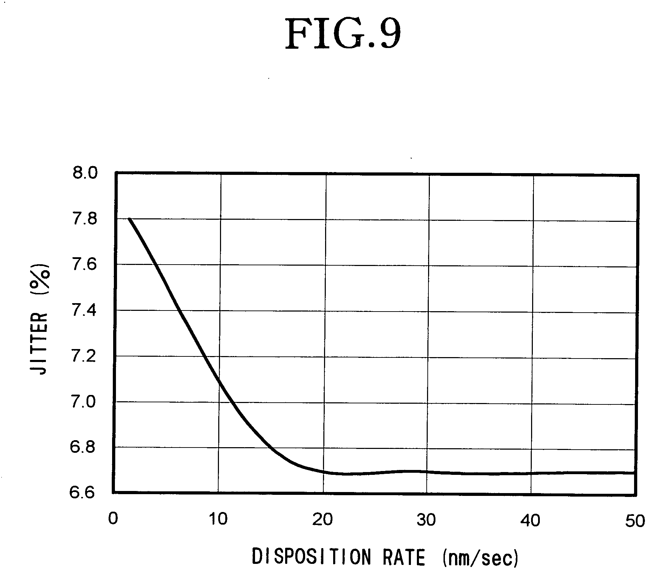

FIG. 9 is a graph showing the relationship between the deposition rate for the reflective layer 12 and the jitter in the produced optical recording media 10.

As shown in FIG. 9, the jitter in the produced optical recording media 10 is seen to tend to decrease the higher the deposition rate for the reflective layer 12. This decrease in jitter is marked in the region in which the deposition rate for the reflective layer 12 is less than approximately 15 nm/sec, but it does not change greatly in the region above approximately 15 nm/sec. Because of this, it is preferable to set the deposition rate for the reflective layer 12 to approximately 15 nm/sec or greater.

Note that in consideration of productivity, the deposition rate for the reflective layer 12 is preferably as high as possible. From this standpoint, the deposition rate for the reflective layer 12 is preferably set to be faster in the region above approximately 15 nm/sec. However, the problems described above occur when the deposition rate in sputtering is set too high, so it is preferable that the deposition rate for the reflective layer 12 be set to a rate no greater than approximately 50 nm/sec.

Summarizing the above, the deposition rate for the reflective layer 12 is preferably set in the range of approximately 15-50 nm/sec.

In this manner, with the method of manufacturing optical recording media according to this embodiment, the reflective layer 12, second dielectric layer 13, recording layer 14, first dielectric layer 15 and transparent layer 16 are formed sequentially upon the substrate 11, and in the formation of the recording layer 14 the deposition rate is set to approximately 5 nm/sec or greater, while in the formation of the reflective layer 12 the deposition rate is set to approximately 15 nm/sec or greater, so it is possible to produce optical recording media 10 with little jitter.

In addition, with the method of manufacturing optical recording media according to this embodiment, sputtering is performed using the inside mask 30 with the bevel 33 and the outside mask 40 with the bevel 43, thereby preventing contact between the layer formed by sputtering and the inside mask 30 and outside mask 40. This effectively suppresses the occurrence of abnormal electrical discharge that happens when these come into contact, so deterioration of the layer quality is prevented and the quality of the optical recording media can be increased.

Note that the width and angle of the bevels 33 and 43 are preferably set in consideration of the gas pressure during sputtering. To wit, when it is necessary to set a relatively high gas pressure during sputtering, the portions that are in the shadow of the bevels 33 and 43 with respect to the target have a heavier coverage with deposition material, so it is necessary to widen the width of the bevels 33 and 43 or make the angle smaller. Conversely, when it is necessary to set a relatively low gas pressure during sputtering, the portions that are in the shadow of the bevels 33 and 43 with respect to the target have a lighter coverage with deposition material, so it is possible to narrow the width of the bevels 33 and 43 or make the angle larger.

The present invention is in no way limited to the aforementioned embodiment, but rather various modifications are possible within the scope of the invention as recited in the claims, and these are naturally included within the scope of the invention.

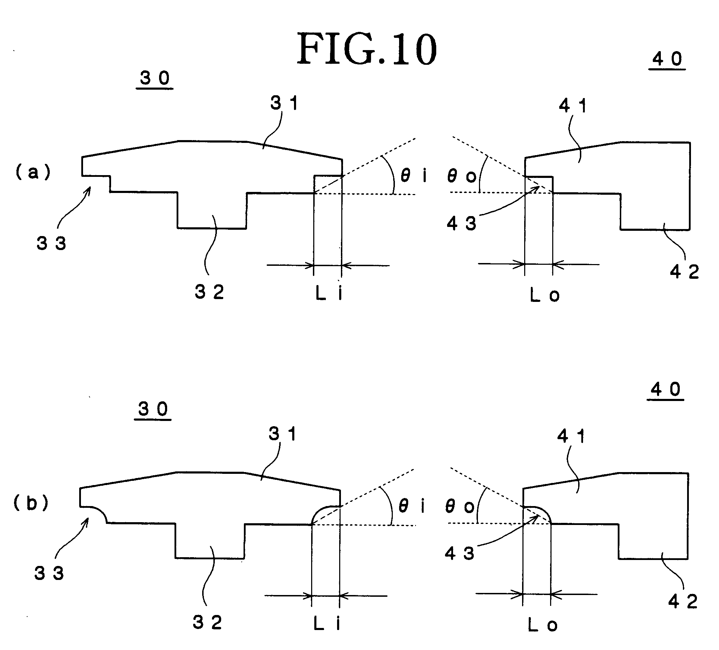

For example, the inside mask 30 used in the aforementioned embodiment has a bevel 33 where the region up to a distance of $L_i$ from the edge of the main body 31 is cut away at an angle of $\theta_i$, and the outside mask 40 has a bevel 43 where the region up to a distance of $L_o$ from the edge of the main body 41 is cut away at an angle of $\theta_o$, but the shape of the cutaway portion is not limited thereto, but rather, the shape of the cutaway portion may be that shown in FIG. 10(a) and (b) as long as a portion that is in shadow with respect to the target is formed on the surface subject to deposition, and this prevents contact between the mask and the reflective layer.

In addition, the materials for the substrate 11, reflective layer 12, second dielectric layer 13, recording layer 14, first dielectric layer 15 and transparent layer 16 illustrated in the aforementioned embodiment are merely one preferred example for the optical recording media manufactured by the method according to the present invention, as the present invention is also applicable to the manufacture of optical recording media made of other materials.

For example, where an alloy of silver is used as the material for the reflective layer 12 in the aforementioned embodiment, the material for the reflective layer 12 is in no way limited thereto, but rather other materials such as aluminum or alloys thereof or the like may be used to form the reflective layer 12 as long as they have a sufficiently high reflectivity with respect to the laser beam. However, in consideration of the reflectivity with respect to the laser beam, flatness at the time of deposition and thermal conductivity, the use of an alloy of silver is most preferable.

In addition, while $Al_2O_3$ is used as the material for the second dielectric layer 13 in the aforementioned embodiment, the material for the second dielectric layer 13 is in no way limited thereto, but rather other materials such as $ZnS-SiO_2$ or SiN or the like may be used to make the second dielectric layer 13. If the second dielectric layer 13 is made using SiN, then it is sufficient to use SiN as the target, or use Si as the target and add $N_2$ to the discharge gas and perform reactive sputtering where deposition occurs while these materials react.

Moreover, while AgInSbTeGe is used as the material for the recording layer 14 in the aforementioned embodiment, the material for the recording layer 14 is in no way limited thereto, but rather other materials such as InSbTeGe or SbTeGe or the like may be used to make the recording layer 14. In addition, the recording layer 14 may also have a multilayer structure consisting of a plurality of laminated materials.

In addition, while $ZnS-SiO_2$ is used as the material for the first dielectric layer 15 in the aforementioned embodiment, the material for the first dielectric layer 15 is in no way limited thereto, but rather other materials such as SiN or the like may be used to make the first dielectric layer 15. If the first dielectric layer 15 is made using SiN, then it is sufficient to use SiN as the target, or use Si as the target and add $N_2$ to the discharge gas and perform reactive sputtering where deposition occurs while these materials react. In addition, the recording layer 14 may also have a multilayer structure consisting of a plurality of laminated materials. In this case, the first dielectric layer 15 may consist of a plurality of layers of $ZnS-SiO_2$ that have different ratios of ZnS and $SiO_2$, or it may have a multilayer structure consisting of layers of $ZnS-SiO_2$ and other dielectric layers.

Moreover, while the reflective layer 12 is formed directly on the surface of the substrate 11 in the aforementioned embodiment, other dielectric layers may be interposed between these layers. These dielectric layers function as moisture-proofing layers for the reflective layer 12 so they may increase the reliability of the produced optical recording media 10. These dielectric layers may be deposited by sputtering.

In addition, the aforementioned thicknesses of the substrate 11, reflective layer 12, second dielectric layer 13, recording layer 14, first dielectric layer 15 and transparent layer 16 formed in this embodiment represent merely one example of the present invention, as the present invention is in no way limited to them.

As described above, with the present invention, the deposition rate of the recording layer 14 is set appropriately so it is possible to manufacture optical recording media 10 with little jitter. The meritorious effects of the present invention are particularly more marked the smaller the groove width, track pitch and groove depth. Accordingly, by using high-*NA* lenses wherein $NA>0.8$ and short-wavelength laser beams with a wavelength of $\lambda<450$ nm, the present invention is particularly suited to the manufacture of optical recording media used in systems wherein the bit length is set to $<0.2\ \mu m/$ bit.

In addition, with the present invention, sputtering is performed using masks that have bevels, so contact between the masks and layers formed by sputtering is prevented. Thus, the occurrence of abnormal electrical discharge that happens when these touch is effectively suppressed, so it is possible to prevent the deterioration of layer quality and increase the quality of the optical recording media. Accordingly, the present invention is particularly effective in the manufacture of optical recording media including a step wherein one or two or more layers are formed by sputtering upon the reflective layer.

**WORKING EXAMPLES**

[Working Example 1]

First, a stamper is used to form by injection molding a substrate 11 with a thickness of approximately 1.1 mm that has a pre-groove with groove width of 0.15 μm, track pitch of approximately 0.3 μm, and a groove depth of approximately 20 nm.

Next, the substrate 11, inside mask 30 and outside mask 40 are placed upon the substrate holder 20 shown in FIG. 3, and this is placed on a stage with the surface that has the pre-groove exposed in the first chamber of a Balzers sputtering system (Big Sprinter), along with a target made of an alloy of silver and then the argon gas pressure within the chamber is set to 0.5 Pa. The bevel 33 of the inside mask 30 used has an angle $\theta_i$ of 30 degrees and the cutaway distance $L_i$ is 0.4 mm. In addition, the bevel 43 of the outside mask 40 used has an angle $\theta_o$ of 32 degrees and the cutaway distance $L_o$ is 0.4 mm. Stainless steel is used as the material for the inside mask 30 and outside mask 40.

In this state, 3.0 kW of electric power is applied to the target to generate a glow discharge, and thus, a layer consisting of an alloy of silver is deposited on the surface of the substrate 11 that has the pre-groove at a deposition rate of approximately 30 nm/sec. This deposition is performed until the layer thickness becomes approximately 100 nm, and thus a reflective layer 12 consisting of an alloy of silver is formed on the surface of the substrate 11.

Next, while maintaining the evacuated state, the substrate holder 20 is moved to the second chamber of the same sputtering system, and this is placed on a stage with the reflective layer 12 exposed in the same chamber, along with an $Al_2O_3$ target and then the argon gas pressure within the chamber is set to 0.6 Pa. In this state, 3.0 kW of electric power is applied to the target to generate a glow discharge, and thus, a layer of $Al_2O_3$ is deposited on the surface of the reflective layer 12 at a deposition rate of approximately 1.2 nm/sec. This deposition is performed until the layer thickness becomes approximately 20 nm, and thus a second dielectric layer 13 consisting of $Al_2O_3$ is formed on the surface of the reflective layer 12.

Next, while maintaining the evacuated state, the substrate holder 20 is moved to the third chamber of the same sputtering system, and this is placed on a stage with the second dielectric layer 13 exposed in the same chamber, along with a mixed target made of Ag, In, Sb, Te and Ge and then the argon gas pressure within the chamber is set to 0.5 Pa. In this state, 3.0 kW of electric power is applied to the target to generate a glow discharge, and thus, a layer of AgInSbTeGe is deposited on the surface of the second dielectric layer 13 at a deposition rate of approximately 6 nm/sec. This deposition is performed until the layer thickness becomes approximately 12 nm, and thus a recording layer 14 consisting of AgInSbTeGe is formed on the surface of the second dielectric layer 13.

Next, while maintaining the evacuated state, the substrate holder 20 is moved to the fourth chamber of the same sputtering system, and this is placed on a stage with the recording layer 14 exposed in the same chamber, along with a mixed target made of ZnS and $SiO_2$ and then the argon gas pressure within the chamber is set to 0.4 Pa. In this state, 4.5 kW of electric power is applied to the target to generate a glow discharge, and thus, a layer of $ZnS$-$SiO_2$ is deposited on the surface of the recording layer 14 at a deposition rate of approximately 10 nm/sec. This deposition is performed until the layer thickness becomes approximately 130 nm, and thus a first dielectric layer 15 consisting of $ZnS$-$SiO_2$ is formed on the surface of the recording layer 14.

Next, the substrate holder 20 is removed from the sputtering system and the surface of the first dielectric layer 15 coated with ultraviolet-curable resin by spin-coating to a thickness of approximately 100 μm. Next, the ultraviolet-cured resin is cured by irradiation with ultraviolet light, and thus a transparent layer 16 with a thickness of approximately 100 μm is formed.

The jitter of the optical recording media 10 thus produced was then measured. The measurement of jitter was performed using a Pulstec Industrial optical recording media evaluation system (DDU-1000: λ=405 nm, *NA*=0.85) and a Yokogawa Electric Time Interval Analyzer (TA-520), the linear speed during recording/playback is set to 5.3 m/sec and the bit length is set to 0.12 μm/bit. As a result, the jitter was found to be 6.8%, thereby exhibiting good results.

[Working Example 2]

An optical recording media 10 was produced under the same conditions as those in Working Example 1 above, except that the deposition conditions for the recording layer 14 were set to an argon gas pressure of approximately 0.5 Pa, power applied to the target of 0.6 kW and deposition rate of approximately 11.2 nm/sec.

The jitter of the optical recording media 10 thus produced was then measured under the same conditions as those in Working Example 1 above. As a result, the jitter was found to be 6.7%, thereby exhibiting results even better than those of Working Example 1.

[Working Example 3]

Optical recording media 10 was produced under the same conditions as those in Working Example 1 above, except that the deposition conditions for the reflective layer 12 were set to an argon gas pressure of approximately 0.5 Pa, power applied to the target of 1.5 kW and deposition rate of approximately 15 nm/sec.

The jitter of the optical recording media 10 thus produced was then measured under the same conditions as those in Working Example 1 above. As a result, the jitter was found to be 6.8%, thereby exhibiting the same results as in Working Example 1.

[Working Example 4]

Optical recording media 10 was produced under the same conditions as those in Working Example 1 above, except that the deposition conditions for the reflective layer 12 were set to an argon gas pressure of approximately 0.5 Pa, power applied to the target of 4.5 kW and deposition rate of approximately 45 nm/sec.

The jitter of the optical recording media 10 thus produced was then measured under the same conditions as those in Working Example 1 above. As a result, the jitter was found to be 6.8%, thereby exhibiting the same results as in Working Example 1.

[Comparative Example 1]

Optical recording media 10 was produced under the same conditions as those in Working Example 1 above, except that the deposition conditions for the recording layer 14 were set to an argon gas pressure of approximately 0.5 Pa, power applied to the target of 0.15 kW and deposition rate of approximately 3 nm/sec.

The jitter of the optical recording media 10 thus produced was then measured under the same conditions as those in Working Example 1 above. As a result, the jitter was found to be 7.2%, thereby exhibiting a value higher than that of each of Working Examples 1-4.

[Comparative Example 2]

Optical recording media 10 was produced under the same conditions as those in Working Example 1 above, except that the deposition conditions for the recording layer 14 were set to an argon gas pressure of approximately 0.2 Pa, power applied to the target of 0.1 kW and deposition rate of approximately 0.25 nm/sec.

The jitter of the optical recording media 10 thus produced was then measured under the same conditions as those in Working Example 1 above. As a result, the jitter was found to be 7.8%, thereby exhibiting a value higher than that of each of Working Examples 1-4.

**Claims**

1. A method of manufacturing optical recording media wherein a reflective layer, recording layer and transparent layer are formed upon a substrate in this order, and wherein a deposition rate for said recording layer is set to 5 nm/sec or greater.

2. The method of manufacturing optical recording media according to claim 1, wherein a deposition rate for said recording layer is set to 50 nm/sec or less.

3. The method of manufacturing optical recording media according to claim 1 or claim 2, wherein a deposition rate for said reflective layer is set to 15 nm/ sec or greater.

4. The method of manufacturing optical recording media according to any of claims 1-3, wherein the second dielectric layer is formed by sputtering between said reflective layer and said recording layer, and the first dielectric layer is formed by sputtering between said recording layer and said transparent layer.

5. The method of manufacturing optical recording media according to claim 4, wherein the sputtering steps from the formation of the reflective layer through the formation of the first dielectric layer are performed continuously while maintaining the evacuated state.

6. An optical recording media manufacturing apparatus for performing a method according to any one of claims 1-5.

7. A method of manufacturing optical recording media comprising: a first step of forming a reflective layer by sputtering in a deposition region upon the substrate demarcated by at least one mask and a second step of forming one or more layers by sputtering in the deposition region upon said reflective layer demarcated by said mask, wherein said second step is performed in the state wherein said mask is not in contact with said reflective layer.

8. The method of manufacturing optical recording media according to claim 7, wherein bevels are provided on said mask in order to form portions that are in shadow with respect to the target, thereby preventing contact between said mask and said reflective layer.

9. The method of manufacturing optical recording media according to claim 8, wherein the width of said bevels is 0.1-1.0 mm.

10. The method of manufacturing optical recording media according to claim 8 or claim 9, wherein the angle of said bevels is 5-85 degrees.

11. The method of manufacturing optical recording media according to any of claims 7-10, wherein the gas pressure for sputtering in the first step and second step is set to 0.1-1.0 Pa.

12. The method of manufacturing optical recording media according to any of claims 7-11, wherein said at least one mask includes an inside mask that demarcates the inside of said deposition region and an outside mask that demarcates the outside of said deposition region.

13. The method of manufacturing optical recording media according to any of claims 7-12, wherein said second step includes a recording layer deposition step wherein at least the recording layer is formed at a deposition rate of 5 nm/sec.

14. The method of manufacturing optical recording media according to claim 13, wherein the deposition rate in said recording layer deposition step is set to 50 nm/sec or less.

15. The method of manufacturing optical recording media according to claim 13 or claim 14, wherein the deposition rate for said reflective layer in said first step is set to 15 nm/sec or greater.

# FIG.1

LASER BEAM

16
15
14
13
12

11

17

# FIG.2

```
PRODUSE SUBSTRATE 11
BY INJECTION MOLDING            ⟶ S1

FORM REFLECTIVE LAYER 12
BY SPUTTERING                   ⟶ S2

FORM SECOND DIELECTRIC LAYER 13
BY SPUTTERING                   ⟶ S3

FORM RECORDING LAYER 14
BY SPUTTERING                   ⟶ S4

FORM FIRST DIELECTRIC LAYER 15
BY SPUTTERING                   ⟶ S5

FORM TRANSPARENT LAYER 16
BY SPIN-COATING                 ⟶ S6
```

# FIG.3

# FIG.4

# FIG.5

# FIG.6

# FIG.7

# FIG.8

# FIG.9

# FIG.10

EP 1 293 975 A2

# FIG.11

LASER BEAM